# FASCICULE DE BREVET EUROPEEN

(11) **EP 2 740 153 B1**
(45) Date de publication et mention de la délivrance du brevet: **04.04.2018**
(21) Numéro de dépôt: 12758526.3
(22) Date de dépôt: 30.07.2012
(51) Int. Cl.: G06F 1/20, H01L 23/34, H01L 23/373, H01L 23/46, H01L 23/38, H01L 23/473, H05K 7/20

(54) **DISPOSITIF DE REFROIDISSEMENT MUNI D'UN CAPTEUR THERMOELECTRIQUE**
KÜHLVORRICHTUNG MIT EINEM THERMOELEKTRISCHEN SENSOR
COOLING DEVICE PROVIDED WITH A THERMOELECTRIC SENSOR

(30) Priorité: 02.08.2011 FR 1102425
(43) Date de publication de la demande: 11.06.2014
(73) Titulaire: Commissariat à l'Énergie Atomique et aux Énergies Alternatives, 75015 Paris (FR)
(72) Inventeur: SAVELLI Guillaume, F- 38000 Grenoble (FR); CORONEL Philippe, F-38530 Barraux (FR)
(74) Mandataire: Talbot, Alexandre
(86) Numéro de dépôt international: PCT/FR2012/000319
(87) Numéro de publication internationale: WO 2013/017750

(56) Documents cités:
- JP-A- S6 138 381
- JP-A- 2005 117 835
- US-A- 3 807 489
- US-A- 5 966 940
- US-A1- 2006 180 300
- US-A1- 2009 200 007
- US-A1- 2010 155 047
- US-A1- 2010 290 188
- US-B1- 6 711 904
- M. PRAKASH ET AL: "Microfluidic Bubble Logic", SCIENCE, vol. 315, no. 5813, 9 février 2007 (2007-02-09), pages 832-835, XP055020387, ISSN: 0036-8075, DOI: 10.1126/science.1136907 cité dans la demande
- LAHANN J ET AL: "A reversible Switching Surface", SCIENCE, US AMERICAN ASSOCIATION FOR THE ADVANCEMENT OF SCIENCE, WASHINGTON, DC, vol. 299, 17 janvier 2003 (2003-01-17), pages 371-374, XP002490005, DOI: 10.1126/SCIENCE.1078933
- TAOLEI SUN ET AL: "Reversible Switching between Superhydrophilicity and Superhydrophobicity", ANGEWANDTE CHEMIE INTERNATIONAL EDITION, vol. 43, no. 3, 5 janvier 2004 (2004-01-05), pages 357-360, XP055020383, ISSN: 1433-7851, DOI: 10.1002/anie.200352565 cité dans la demande
- Wanwipa Siriwatwechakul ET AL: "Thermo-Sensitive Hydrogel: Control of Hydrophilic-Hydrophobic Transition", World Academy of Science, Engineering and Technology, 1 janvier 2008 (2008-01-01), pages 429-434, XP055020766, Extrait de l'Internet: URL:http://www.waset.org/journals/waset/v4 7/v47-78.pdf [extrait le 2012-03-02]

## Description

### Domaine technique de l'invention

L'invention est relative à la gestion thermique de composants, et plus particulièrement à un dispositif de refroidissement muni d'un fluide caloporteur en circulation.

### État de la technique

L'intégration massive de composants dans les systèmes électroniques pose inévitablement le problème du refroidissement. En effet, plus les composants sont nombreux dans un volume donné, plus le système électronique chauffe et plus le risque de détérioration due à une surchauffe est important.

Il existe différentes solutions de refroidissement. Les dispositifs de refroidissement passifs utilisent un radiateur ou des via thermiques pour évacuer la chaleur des composants vers l'extérieur. L'utilisation d'un radiateur est contraignante pour l'intégration du système électronique dans un appareil de taille réduite, tel qu'un téléphone portable. Les via thermiques performants, par exemple en nanotubes de carbone, sont difficiles à fabriquer et complexifient l'architecture du système.

Les dispositifs passifs peuvent être associés à une ventilation d'air afin d'améliorer les performances de refroidissement. Lorsque la convection d'air, naturelle ou forcée, n'est plus suffisante pour évacuer l'énergie dissipée par le système, il convient d'utiliser un liquide de refroidissement en circulation.

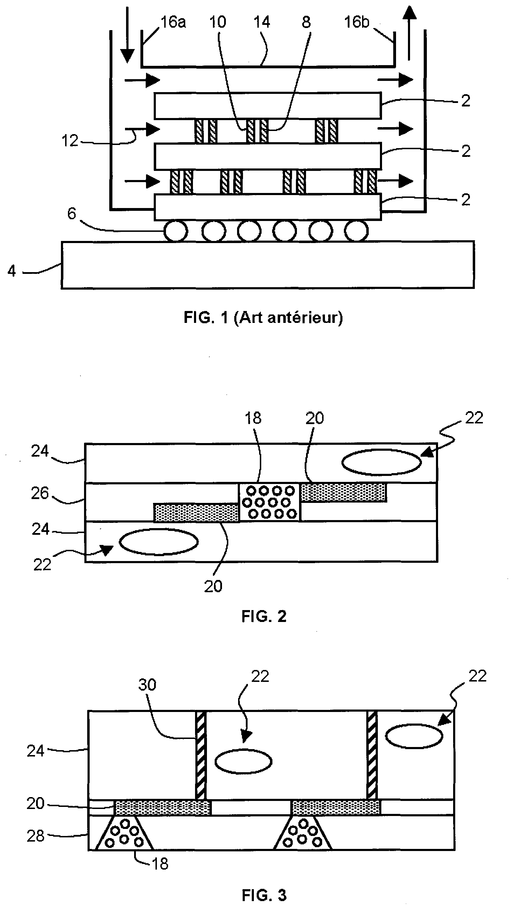

La figure 1 représente schématiquement un système électronique refroidi par un liquide en circulation, tel que décrit dans la demande de brevet US2010/0290188.

Le système électronique est formé d'un empilement de circuits intégrés 2. L'empilement est fixé à un circuit imprimé 4 à l'aide de billes de soudure 6. Les circuits 2 sont interconnectés par des via métalliques 8, formés dans des plots 10 en silicium.

Les circuits intégrés 2 de l'empilement sont espacés entre eux, à l'aide des plots d'interconnexion 10. Ces espacements permettent la circulation d'un liquide de refroidissement 12. Le liquide 12 circule également entre le circuit 2 supérieur et une paroi d'un boîtier 14 servant de structure de confinement au liquide. Le boîtier 14 comprend un orifice d'entrée 16a et un orifice de sortie 16b du liquide de refroidissement, disposés de part et d'autre de l'empilement. Ainsi, le flux de liquide 12, généré par une pompe, circule en contact des circuits 2 d'une extrémité à l'autre du boîtier 14.

Dans ce type de système, le contrôle du débit du liquide de refroidissement est assuré par la pompe. Le débit est généralement fixé à une valeur élevée pour assurer un refroidissement maximal quelles que soient les conditions thermiques du système. Ce contrôle ne tient pas compte du besoin réel de refroidissement au niveau des composants. La consommation de liquide, et donc la consommation électrique de la pompe, ne sont pas optimisées.

Le document US5966940 divulgue un dispositif de gestion de la température d'un composant semi-conducteur. Le composant est disposé sur une plaque thermique contenant un capteur de température, par exemple un thermocouple fonctionnant ne mode Peltier. Le capteur est installé dans la zone chaude.

Le document JP S6138381 traite d'un dispositif de refroidissement muni de deux thermomètres configurés pour mesurer respectivement la température ambiante et la température du liquide de refroidissement. Le dispositif de refroidissement est configuré pour éviter la condensation sur le circuit de refroidissement.

Le document JP 2005117835 traite d'un détecteur de température comprenant un module thermoélectrique dont la dégradation au cours du temps est prise en compte. Le module thermoélectrique comporte plusieurs éléments thermoélectriques.

### Résumé de l'invention

On constate qu'il existe un besoin de prévoir un dispositif permettant un refroidissement optimisé tout en ayant une consommation électrique et fluidique réduite.

On tend à satisfaire ce besoin en prévoyant un dispositif de refroidissement d'un composant comprenant au moins un canal dans lequel circule un premier fluide caloporteur destiné à refroidir une zone chaude du composant. Le dispositif comporte un module thermoélectrique configuré pour mesurer une différence de température entre la zone chaude du composant et le canal, et un circuit de contrôle configuré pour moduler le débit du premier fluide caloporteur dans le canal en fonction de la différence de température.

Dans un mode de réalisation préférentiel, la surface du canal en contact avec le premier fluide caloporteur est recouverte d'une couche en matériau polymère présentant une première énergie de surface sous une première condition d'excitation et une deuxième énergie de surface sous une deuxième condition d'excitation, les première et deuxième conditions d'excitation étant fixées par le circuit de contrôle.

Selon un développement, la couche en matériau polymère est une monocouche auto-assemblée comprenant des particules d'acide mercapto-hexadécanoïque et le module thermoélectrique est configuré pour appliquer une variation de température à la monocouche auto-assemblée représentative des première et deuxième conditions d'excitation.

Selon un autre développement, la couche en matériau polymère comprend des monomères d'isopropylacrylamide et le circuit de contrôle est configuré pour appliquer une variation de potentiel électrique à la couche en matériau polymère représentative des première et deuxième conditions d'excitation.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente un dispositif classique de refroidissement d'un système électronique ;
- la figure 2 représente un mode de réalisation de dispositif de refroidissement selon l'invention ;
- la figure 3 représente une variante de réalisation de dispositif de refroidissement selon l'invention ;
- la figure 4 représente un schéma synoptique d'un dispositif de refroidissement selon l'invention ;
- la figure 5 représente différentes configurations d'un circuit de refroidissement utilisé dans le dispositif de refroidissement selon l'invention ; et
- les figures 6 à 8 représentent des étapes de fabrication d'un dispositif de refroidissement selon la figure 3.

### Description d'un mode de réalisation préféré de l'invention

Afin d'optimiser le débit de fluide caloporteur dans un circuit de refroidissement, on dispose un capteur thermoélectrique entre le circuit de refroidissement et une zone chaude d'un composant à refroidir. Ce capteur mesure les caractéristiques de l'environnement thermique du composant, en particulier la différence de température entre le composant et le fluide caloporteur. Le capteur est couplé à un circuit de contrôle qui régule le débit de fluide caloporteur en fonction de cette différence de température. Le débit du fluide est ainsi adapté, en continu, aux besoins de refroidissement du composant.

La figure 2 représente un mode de réalisation de dispositif de refroidissement muni d'un module thermoélectrique.

Le dispositif de refroidissement comprend un circuit de refroidissement 18 et un module thermoélectrique 20, disposé entre le circuit 18 et une zone chaude 22 du composant. Le circuit de refroidissement 18 comprend au moins un canal ou caloduc dans lequel circule le fluide caloporteur. Avantageusement, le circuit 18 est formé d'un réseau de canaux.

Une première extrémité du module 20 est en contact thermique avec le réseau de canaux 18, formant une source froide, et une deuxième extrémité est en contact thermique avec la source chaude 22. Le module thermoélectrique 20 est ainsi soumis à une différence de température à ses extrémités. Il est en outre relié électriquement à un circuit de contrôle (non représenté sur la figure 2).

Dans ce mode de réalisation, le dispositif de refroidissement est intégré au composant à refroidir. A titre d'illustration, le composant est formé d'un empilement de circuits intégrés 24, chaque circuit intégré disposant d'une zone chaude 22. Les circuits intégrés 24 sont classiquement séparés par une couche d'interconnexion 26 contenant des via métalliques. Ces via relient électriquement les circuits intégrés 24. Le circuit de refroidissement 18 et le module thermoélectrique 20 sont, de préférence, formés dans la couche d'interconnexion 26.

Comme cela est représenté sur la figure 2, un même réseau de canaux 18 peut participer au refroidissement de plusieurs zones chaudes 22, chaque zone 22 étant séparée du réseau 18 par un module thermoélectrique.

Avantageusement, le dispositif de refroidissement comprend plusieurs circuits de refroidissement et plusieurs modules thermoélectriques, répartis dans des niveaux différents de l'empilement. Il est alors possible de refroidir individuellement chaque circuit intégré de l'empilement. Les circuits de refroidissement peuvent être indépendants ou reliés pour former un unique réseau de distribution du fluide caloporteur.

Le fluide caloporteur est un gaz ou un liquide à une température inférieure à celle du composant dans la zone chaude. Il est, de préférence, choisi parmi l'eau, l'azote et un alcool.

La figure 3 représente une variante de réalisation de dispositif de refroidissement, dans laquelle le circuit de refroidissement est déporté du composant.

Le dispositif comprend une couche de refroidissement 28, dans laquelle sont formés les canaux 18, et au moins un module thermoélectrique 20 formé sur la couche 28. La couche 28 et le module 20 sont surmontés d'au moins un composant 24 à refroidir.

Dans l'exemple de la figure 3, le composant 24 comprend deux points chauds 22, chacun étant associé à un ensemble de canaux 18 et un module 20. Une extrémité de chaque module 20 est en contact thermique avec les canaux 18. L'autre extrémité est en contact thermique avec un point chaud 22, de préférence par l'intermédiaire d'un via thermique 30 (appelé également pont thermique).

Les via thermiques 30 sont formés d'un matériau ayant une conductivité thermique élevée, de préférence supérieure à la conductivité thermique du matériau formant le composant 24. Les via 30 sont, par exemple, formés d'un métal. Dans ce cas, les via 30 peuvent réaliser la connexion électrique des modules thermoélectriques 20 au circuit de contrôle, disposé par exemple au-dessus du composant 24 ou sur le même substrat que celui du composant 24.

La couche 28 constitue un support dans lequel est formé le circuit fluidique. Ce support est, par exemple, en silicium et peut en outre servir à former le circuit de contrôle. La couche 28 peut aussi être formée d'un matériau isolant thermique comme le verre.

Dans cette configuration, une couche de refroidissement 28, recouverte de modules thermoélectriques 20, peut servir à refroidir plusieurs composants 24 empilés. Comme cela sera décrit plus loin, cette variante du dispositif de refroidissement est particulièrement simple à mettre en oeuvre. Le dispositif de refroidissement et le composant peuvent être fabriqués séparément, puis le composant est rapporté sur le dispositif de refroidissement.

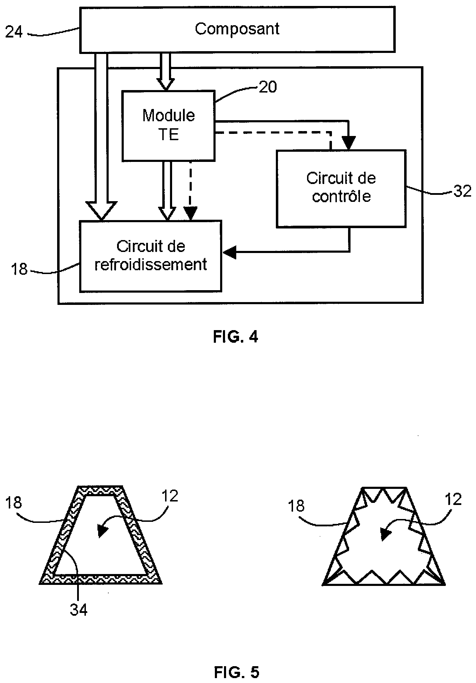

La figure 4 représente un schéma synoptique du dispositif de refroidissement des figures 2 et 3, couplé à un composant 24. Les flèches noires représentent les signaux électriques reçus et envoyés par les différents éléments du dispositif tandis que les flèches blanches représentent le flux de chaleur.

Le module thermoélectrique 20 (TE) mesure la différence de température entre le composant 24 et le circuit de refroidissement 18. Un signal électrique représentatif de cette différence, par exemple la tension aux extrémités du module 20, est transmis au circuit de contrôle 32. Le circuit de contrôle 32 commande le circuit de refroidissement 18 de manière à modifier le flux du fluide caloporteur en fonction de la différence de température.

La chaleur du composant est en grande partie évacuée par le réseau de canaux 18. Ce transfert de chaleur s'effectue par conduction thermique des différentes couches séparant la zone chaude 22 et le réseau de canaux 18.

Le module thermoélectrique 20 participe également au refroidissement du composant. En effet, une partie du flux de chaleur traverse le matériau thermoélectrique, de la source chaude 22 à la source froide 18. Ce transfert est toutefois limité en raison du faible volume occupé par le module thermoélectrique et de la faible conductivité thermique des matériaux qui le constituent.

Le circuit de contrôle 32 comprend, par exemple, un amplificateur du signal de mesure, en sortie du capteur thermoélectrique 20, un algorithme de traitement sous la forme d'un microprocesseur et un circuit de génération des signaux de commande. Lorsque plusieurs modules thermoélectriques sont utilisés, le circuit de contrôle reçoit et traite tous les signaux de mesure, par exemple simultanément.

La figure 5 représente des exemples de circuit de refroidissement permettant de moduler le débit de fluide caloporteur. Dans ces exemples, le circuit de refroidissement a été simplifié : il est formé d'un seul canal 18, de section trapézoïdale.

Dans un mode de réalisation préférentiel, le débit de fluide caloporteur 12 est modulé en faisant varier l'énergie de surface entre le canal 18 et le fluide 12. Pour cela, la surface du canal en contact avec le fluide est recouverte d'une couche en matériau polymère 34.

Le circuit de contrôle envoie un stimulus électrique ou thermique à la couche 34. Celui-ci modifie la structure interne de la couche polymère 34 et donc son énergie de surface. Dans le cas de l'eau comme fluide caloporteur, cela revient à modifier la mouillabilité de la surface du canal, c'est-à-dire son caractère hydrophile ou hydrophobe.

En d'autres termes, le circuit de contrôle 32 définit des conditions d'excitation, pour faire passer la couche polymère 34 d'un premier état à un second état, l'énergie de surface du polymère étant différente entre les deux états.

La couche polymère est, par exemple, une monocouche auto-assemblée (SAM, « Self-Assembled Monolayer ») telle que décrite dans l'article « Réversible Switching between Superhydrophilicity and Superhydrophobicity » (Taolei et al., Angew. Chem. Int., 43, 357-360, 2004). Elle comprend des molécules d'acide mercapto-hexadécanoïque (MHA). Selon qu'on applique un potentiel électrique positif ou négatif sur le canal, la couche polymère présente un caractère hydrophobe ou hydrophile.

Alternativement, la couche polymère comprend des monomères de N-isopropylacrylamide (PNIPAM), décrits dans l'article « A réversible Switching Surface ». Ces monomères sont sensibles à la température. La couche polymère devient hydrophobe en la chauffant au-delà d'une température donnée, de l'ordre de 32 °C. A l'inverse, elle devient hydrophile en la refroidissant en dessous de cette température.

D'autres types de molécules peuvent être envisagées, comme le poly(acrylamide n-substitué), le poly(N-(L)-(1-hydroxyméthyle) propylméthacrylamide) (P(L-HMPMAAm)), et le poly(N-acryloyl-N0-alkylpipérazine). Ces exemples de polymère réagissent à des stimuli thermiques.

Certaines de ces molécules se greffent sur un type particulier de surface pour former une monocouche auto-assemblée SAM. Le canal 18 est alors formé dans un matériau permettant la greffe des molécules utilisées, par exemple l'or dans le cas des molécules MHA.

Ainsi, il est possible de contrôler le débit dans le circuit de refroidissement en modifiant les propriétés de la couche en matériau polymère. Une surface rendue hydrophobe limitera la circulation d'eau, en réduisant la section du canal. A l'inverse, un canal dont la surface est hydrophile favorise la circulation d'eau et augmente donc le débit.

Le stimulus électrique est, de préférence, transmis par le module thermoélectrique à la couche polymère. Le module thermoélectrique est relié électriquement au circuit de contrôle. Le circuit de contrôle peut donc envoyer un signal électrique à la couche polymère, par l'intermédiaire du module thermoélectrique (flèche en traits pointillés sur la figure 4).

En outre, le module évacue directement une partie du flux de chaleur au circuit de refroidissement. Ce transfert de chaleur peut donc servir à modifier localement la structure de la couche polymère. En d'autres termes, le module thermoélectrique, en contact direct avec le canal, transmet l'information thermique provoquant la modification de la couche polymère.

La surface du canal 18 recouverte de matériau polymère dépend de la variation maximale de débit envisagée. A titre d'exemple, si l'on souhaite interrompre complètement la circulation du fluide caloporteur, la couche polymère 34 pourra être déposée sur toute la surface du canal 18 (Fig.5). Le fluide sera alors dirigé vers une autre branche du circuit de refroidissement, pour évacuer la chaleur d'un autre composant. Le matériau polymère peut être déposé sur une seule paroi du canal 18 lorsque qu'on souhaite faire varier le débit dans une moindre mesure.

La couche polymère 34 est, de préférence, déposée sur le canal 18 au voisinage du module thermoélectrique 20. Elle peut également être disposée en amont ou en aval du module thermoélectrique dans le sens de circulation du fluide. On prévoit alors un conducteur thermique ou électrique additionnel, distinct de module thermoélectrique, pour acheminer le signal associé.

Comme cela est représenté à droite sur la figure 5, la surface du canal 18 en contact avec le fluide 12 est avantageusement structurée afin d'effectuer un contrôle plus précis de l'énergie de surface.

Le dispositif de refroidissement décrit ci-dessus permet l'utilisation d'un circuit de refroidissement 18 fermé. En effet, en modifiant l'énergie de surface localement, en plusieurs zones consécutives du circuit 18, il est possible de créer un mouvement du fluide caloporteur. Un circuit fermé est particulièrement intéressant pour les applications nomades. En effet, on s'affranchit alors d'une pompe pour forcer la circulation du fluide caloporteur, ce qui représente un gain de consommation ainsi qu'un gain de place.

Le circuit de contrôle 32 peut également commander une vanne d'introduction reliée à un réservoir d'un fluide caloporteur additionnel. Ce second fluide caloporteur présente, de préférence, une capacité thermique différente de celle de premier fluide. Ainsi, lorsque le second fluide est introduit dans le circuit 18, il augmente ou diminue le pouvoir de refroidissement (ou pouvoir calorifique) du premier fluide caloporteur.

Dans un mode de réalisation, les deux fluides sont choisis pour déclencher une réaction endothermique lorsqu'ils sont mélangés. Ils sont, de préférence, acheminés par des canaux distincts, puis mélangés au niveau du module thermoélectrique. L'article « Microfluidic Bubble Logic » (M. Prakash et al, Science, Vol. 315, pp. 832-835, Feb. 2007) décrit un exemple de système fluidique permettant un tel mélange.

On pourra également envisager un fluide caloporteur contenant des molécules polaires et appliquer un champ électrique pour diriger ces molécules.

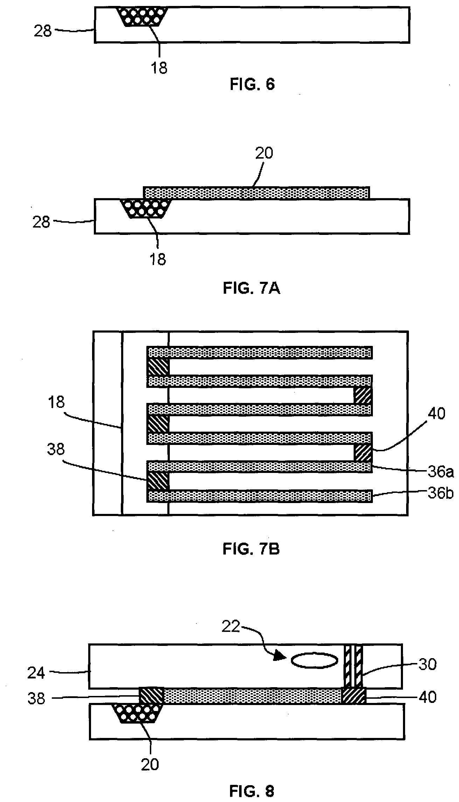

Les figures 6 à 8 représentent des étapes d'un procédé de réalisation d'un dispositif de refroidissement selon la figure 3.

L'étape de la figure 6 correspond à la formation de la couche de refroidissement 28 contenant les canaux 18. Les canaux sont, de préférence, gravés dans un substrat en silicium. Ils ont, par exemple, une forme cylindrique et un diamètre compris entre 10 µm et 1mm. La surface des canaux 18 en contact avec le fluide caloporteur est, le cas échant, recouverte d'une fine couche d'or, d'aluminium ou de titane, de 10 nm à 100 µm d'épaisseur, avant d'y déposer le matériau polymère. L'épaisseur de la couche polymère varie entre 10 nm et 1 µm.

A l'étape de la figure 7A, on forme le module thermoélectrique 20 sur la surface de la couche de refroidissement 28. Une extrémité du module 20 est disposée en contact avec les canaux 18.

Comme cela est représenté en vue de dessus sur la figure 7B, le module thermoélectrique 20 est avantageusement formé d'une pluralité de thermocouples. Chaque thermocouple comprend deux plots thermoélectriques 36a et 36b, reliés entre eux à l'une de leurs extrémités par un connecteur métallique interne 38. Les thermocouples sont connectés électriquement en série à l'aide de connecteurs métalliques de liaison 40.

Les plots 36a et 36b ont des natures thermoélectriques différentes. Par exemple, le plot 36a est en silicium de type P et le plot 36b est en silicium de type N. D'autres matériaux, semi-conducteurs ou semi-métaux, peuvent être envisagés, comme le germanium, le bismuth, l'antimoine et leurs alliages. Les plots 36a et 36b sont, de préférence, de dimensions identiques. Leur épaisseur est, par exemple, comprise entre 5 nm et 500 µm selon le procédé de réalisation utilisé.

Le composant 24 est ensuite collé sur le dispositif de refroidissement (Fig.8). Il comprend, de préférence, des via métalliques 30 destinés à conduire la chaleur de la zone chaude 22, située à l'intérieur du composant, vers le module thermoélectrique 20.

Les connecteurs de liaison 40 sont en contact avec les via métalliques 30, de façon individuelle afin de ne pas former de court-circuit. Les connecteurs internes 36 sont disposés sur les canaux 18. Les thermocouples sont ainsi disposés en parallèle entre une source chaude formée par le composant et une source froide formée par les canaux 18.

Au fur et à mesure qu'on évacue la chaleur du composant, la température (froide) du fluide caloporteur augmente. La régulation du débit (et/ou la modulation de la capacité thermique du fluide), assurée par le circuit de contrôle, permet toutefois de maintenir la température de la source froide à une valeur adéquate. Ainsi, le signal délivré par le capteur thermoélectrique reflète, à chaque instant, les conditions thermiques dans lesquelles se trouve le composant.

Le module thermoélectrique permet de suivre l'évolution de la température du composant et d'adapter en temps réel le débit et le cheminement du fluide caloporteur. La consommation du fluide peut alors être limitée au besoin du composant. Comme le débit de fluide est généralement imposé par une pompe, cela représente une économie d'énergie électrique. En outre, le module thermoélectrique ne consomme pas de courant compte tenu qu'il fonctionne en tant que capteur de température, et non en mode Peltier. On obtient alors un dispositif de refroidissement ayant une consommation électrique inférieure à celles des dispositifs actifs classiques.

Pour les applications nomades, on privilégiera un circuit de refroidissement fermé, c'est-à-dire sans pompe. La consommation électrique du dispositif de refroidissement sera alors minimale et correspondra à celle du circuit de contrôle.

## Revendications

1. Dispositif de refroidissement d'un composant (24) comprenant au moins un canal (18) dans lequel circule un premier fluide caloporteur (12) destiné à refroidir une zone chaude (22) du composant, **caractérisé en ce qu'**il comporte :
- un module thermoélectrique (20) en contact thermique avec la zone chaude (22) à une première extrémité et avec le canal (18) à une deuxième extrémité, le module thermoélectrique (20) étant configuré pour mesurer une différence de température entre la zone chaude (22) du composant et le canal (18); et
- un circuit de contrôle (32) configuré pour moduler le débit du premier fluide caloporteur dans le canal en fonction de la différence de température.

2. Dispositif selon la revendication 1, dans lequel la surface du canal (18) en contact avec le premier fluide caloporteur (12) est recouverte d'une couche en matériau polymère (34) présentant une première énergie de surface sous une première condition d'excitation et une deuxième énergie de surface sous une deuxième condition d'excitation, les première et deuxième conditions d'excitation étant fixées par le circuit de contrôle (32).

3. Dispositif selon la revendication 2, dans lequel la couche en matériau polymère (34) est une monocouche auto-assemblée (SAM) comprenant des particules d'acide mercapto-hexadécanoïque et dans lequel le module thermoélectrique (20) est configuré pour appliquer une variation de température à la monocouche auto-assemblée (SAM) représentative des première et deuxième conditions d'excitation.

4. Dispositif selon la revendication 2, dans lequel la couche en matériau polymère (34) comprend des monomères d'isopropylacrylamide et dans lequel le circuit de contrôle (32) est configuré pour appliquer une variation de potentiel électrique à la couche en matériau polymère représentative des première et deuxième conditions d'excitation.

5. Dispositif selon la revendication 1, comprenant un réservoir d'un deuxième fluide caloporteur ayant une capacité thermique différente de celle du premier fluide caloporteur, et une vanne d'introduction du deuxième fluide caloporteur dans le canal (18) commandée par le circuit de contrôle (32).

6. Dispositif selon la revendication 1, dans lequel le module thermoélectrique (20) est formé par une pluralité de thermocouples connectés électriquement en série et thermiquement en parallèle entre la zone chaude (22) du composant (24) et le canal (18).

7. Dispositif selon la revendication 1, comprenant une pluralité de canaux (18).

## Patentansprüche

1. Kühlvorrichtung für ein Bauteil (24) mit mindestens einem Kanal (18), in dem eine erste wärmeabführende Flüssigkeit (12) zirkuliert, die dazu vorgesehen ist, einen warmen Bereich (22) des Bauteils zu kühlen,
**dadurch gekennzeichnet,**
**dass** sie umfasst:
- ein thermoelektrisches Modul (20), das sich mit einem ersten Ende mit dem warmen Bereich (22) und mit einem zweiten Ende mit dem Kanal (18) in thermischem Kontakt befindet, wobei das thermoelektrische Modul (20) dazu konfiguriert ist, eine Temperaturdifferenz zwischen dem warmen Bereich (22) des Bauteils und dem Kanal (18) zu messen, und
- einen Regelkreis (32), der dazu konfiguriert ist, die Menge der ersten wärmeabführenden Flüssigkeit in dem Kanal in Abhängigkeit von der Temperaturdifferenz zu regulieren.

2. Vorrichtung nach Anspruch 1, wobei die Oberfläche des Kanals (18), die sich in Kontakt mit der ersten wärmeabführenden Flüssigkeit (12) befindet, mit einer Schicht aus Polymer (34) überzogen ist, welche unter einer ersten Erregungsbedingung eine erste Oberflächenenergie und unter einer zweiten Erregungsbedingung eine zweite Oberflächenenergie aufweist, wobei die erste und die zweite Erregungsbedingung durch den Regelkreis (32) festgesetzt werden.

3. Vorrichtung nach Anspruch 2, wobei die Schicht aus Polymer (34) eine selbstorganisierte Monoschicht (SAM) ist, die Partikel von Mercaptohexadecansäure enthält, und wobei das thermoelektrische Modul (20) dazu konfiguriert ist, an der selbstorganisierten Monoschicht (SAM) eine variierende Temperatur zu erzeugen, die die erste und die zweite Erregungsbedingung darstellt.

4. Vorrichtung nach Anspruch 2, wobei die Schicht aus Polymer (34) Isopropylacrylamid-Monomere enthält, und wobei der Regelkreis (32) dazu konfiguriert ist, eine variierende elektrische Spannung an die Schicht aus Polymer anzulegen, die die erste und die zweite Erregungsbedingung darstellt.

5. Vorrichtung nach Anspruch 1, die einen Behälter für eine zweite wärmeabführende Flüssigkeit, welche eine andere Wärmekapazität besitzt als die erste wärmeabführende Flüssigkeit, sowie ein Ventil zum Zuführen der zweiten wärmeabführenden Flüssigkeit in den Kanal (18), das durch den Regelkreis (32) gesteuert wird, umfasst.

6. Vorrichtung nach Anspruch 1, wobei das thermoelektrische Modul (20) von einer Vielzahl von Thermoelementen gebildet ist, die zwischen dem warmen Bereich (22) des Bauteils (24) und dem Kanal (18) elektrisch in Reihe und thermisch parallel geschaltet sind.

7. Vorrichtung nach Anspruch 1, die eine Vielzahl von Kanälen (18) aufweist.

## Claims

1. A cooling device of a component (24) comprising at least one channel (18) in which a first cooling fluid (12) flows designed to cool a hot area (22) of the component, **characterized in that** it comprises:
- a thermoelectric module (20) in thermal contact with the hot area are (22) at a first end and with the at channel (18) at a second end, the thermoelectric module (20) being configured to measure the temperature difference between the hot area (22) of the component and the channel (18); and
- a control circuit (32) configured to modulate the flowrate of the first cooling fluid in the channel according to the temperature difference.

2. The device according to claim 1, wherein the surface of the channel (18) in contact with the first cooling fluid (12) is covered by a polymer material layer (34) presenting a first surface energy under a first excitation condition and a second surface energy under a second excitation condition, the first and second excitation conditions being fixed by the control circuit (32).

3. The device according to claim 2, wherein the polymer material layer (34) is a self-assembled monolayer (SAM) comprising particles of mercapto-hexadecanoic acid and wherein the thermoelectric module (20) is configured to apply a temperature variation to the self-assembled monolayer (SAM) representative of the first and second excitation conditions.

4. The device according to claim 2, wherein the polymer material layer (34) comprises isopropylacrylamide monomers and wherein the control circuit (32) is configured to apply an electric potential variation to the polymer material layer representative of the first and second excitation conditions.

5. The device according to claim 1, comprising a tank of a second cooling fluid having a different thermal capacity from that of the first cooling fluid, and an inlet valve of the second cooling fluid to the channel (18) controlled by the control circuit (32).

6. The device according to claim 1, wherein the thermoelectric module (20) is formed by a plurality of thermocouples electrically connected in series and thermally connected in parallel between the hot area (22) of the component (24) and the channel (18).

7. The device according to claim 1, comprising a plurality of channels (18).
